# EUROPEAN PATENT SPECIFICATION

(11) **EP 4 564 128 B1**
(45) Date of publication and mention of the grant of the patent: **13.05.2026**
(21) Application number: 24212989.8
(22) Date of filing: 14.11.2024
(51) Int. Cl.: G06F 1/16, G09F 9/30, H10K 77/10

(54) **DISPLAY DEVICE AND ELECTRONIC DEVICE INCLUDING THE SAME**
ANZEIGEVORRICHTUNG UND ELEKTRONISCHE VORRICHTUNG DAMIT
DISPOSITIF D'AFFICHAGE ET DISPOSITIF ÉLECTRONIQUE LE COMPRENANT

(30) Priority: 30.11.2023 KR 20230171860
(43) Date of publication of application: 04.06.2025
(73) Proprietor: Samsung Display Co., Ltd., Yongin-si, Gyeonggi-do 17113 (KR)
(72) Inventor: Seo, Eunwon, Yongin-si, Gyeonggi-do (KR); Lee, Joon-Ik, Yongin-si, Gyeonggi-do (KR); Park, Cheuljin, Yongin-si, Gyeonggi-do (KR)
(74) Representative: Gulde & Partner

(56) References cited:
- TW-A- 201 013 604
- US-A1- 2022 358 865
- US-A1- 2023 288 963

## Description

### BACKGROUND

### 1. Technical Field

Embodiments relate to a rollable display device and an electronic device including the same.

### 2. Description of the Related Art

As information technology develops, the importance of display devices, which are communication media between users and information, is being highlighted. Accordingly, the use of display devices, such as a liquid crystal display device, an organic light-emitting display device, a plasma display device, and/or the like is increasing.

Recently, flexible display devices that can be bent are in demand. For example, flexible display devices, such as a foldable display device, a slidable display devices (or a rollable display device), and/or the like are being used. An example may be found in US 2022/358865 A1.

### SUMMARY

The invention is defined by the appended claims. The description that follows is subjected to this limitation. Any disclosure lying outside the scope of said claims is only intended for illustrative as well as comparative purposes. Embodiments provide a display device having improved reliability.
Embodiments provide an electronic device including the display device.

A display device according to embodiments of the present disclosure includes a display module having flexibility, a metal plate under the display module and patterned, and a support plate under the metal plate and including a base part, and support bars surrounded by the base part and extending in a horizontal direction parallel to an upper surface of the display module. The display module may be bendable or rollable.

A thickness of the metal plate may be different from a thickness of the support plate.

A thickness of the metal plate may be between about 0.05 mm and about 0.3 mm.

A thickness of the support plate may be between about 1.0 mm and about 5.0 mm.

The metal plate may include stainless steel.

The metal plate may have a lattice shape in a plan view.

The metal plate may include an auxetic structure having a negative Poisson's ratio.

The auxetic structure of the metal plate may include patterns having a same planar shape and connected to each other.

The auxetic structure of the metal plate may include patterns connected to each other, wherein the patterns include a closed line pattern, and line parts extending from the closed line pattern and spaced apart from each other.

The support bars may be impregnated into the base part.

The support bars may have a polygonal shape in a cross-section.

The base part may include a flexible silicon resin.

The support bars may be repeatedly arranged along a first direction, and may extend in a second direction crossing the first direction.

The support bars may include carbon fiber reinforced plastic (CFRP) or glass fiber reinforced plastic (GFRP).

The display module may include a light-emitting element above a substrate, a color conversion layer above the light-emitting element and including quantum dots, and a color filter layer above the color conversion layer.

An electronic device according to embodiments of the present disclosure includes an accommodating portion, a roller inside the accommodating portion, extending in a first direction, and configured to rotate, and a display device accommodated in the accommodating portion, configured to be rolled by the roller, and including a display module, a metal plate under the display module and patterned, and a support plate under the metal plate, and including a base part, and support bars surrounded by the base part and extending in a direction parallel to the display module.

A thickness of the metal plate may be different from a thickness of the support plate.

A thickness of the metal plate may be between about 0.05 mm and about 0.3 mm.

A thickness of the support plate may be between about 1.0 mm and about 5.0 mm.

The metal plate may have a lattice shape in a plan view.

The metal plate may include an auxetic structure having a negative Poisson's ratio.

The support bars may be repeatedly arranged along the first direction, and extend in a second direction crossing the first direction.

The base part may include a flexible silicon resin, wherein the support bars include carbon fiber reinforced plastic or glass fiber reinforced plastic.

A display device according to one or more embodiments of the present disclosure may include a display module having flexibility, a metal plate located under the display module and patterned, and a support plate located under the metal plate and including a base part and a plurality of support bars surrounded by the base part and each extending in a direction parallel to the display module. The display device may be fixed to a roller and may be rolled or unrolled as the roller rotates. Accordingly, the flexibility and rigidity of the display device may be secured at the same time.

### BRIEF DESCRIPTION OF THE DRAWINGS

Illustrative, non-limiting embodiments will be more clearly understood from the following detailed description in conjunction with the accompanying drawings.
FIG. 1 is a perspective view illustrating an electronic device according to one or more embodiments of the present disclosure.
FIG. 2 is a perspective view illustrating a roller located inside an accommodating portion of FIG. 1 and a display device fixed by the roller.
FIG. 3 is a perspective view illustrating the display device of FIG. 1 in a rolled state.
FIG. 4 is a cross-sectional view illustrating the display device of FIG. 1.
FIG. 5 is a plan view illustrating one pixel of FIG. 1.
FIG. 6 is a cross-sectional view taken along the line I-I' of FIG. 5.
FIGS. 7 and 8 are plan views illustrating examples of a metal plate of FIG. 4.
FIGS. 9, 10, 11, 12, 13, 14, and 15 are plan views illustrating other examples of a metal plate of FIG. 4.
FIG. 16 is a plan view illustrating a support plate of FIG. 4.
FIGS. 17 and 18 are cross-sectional views illustrating examples of a support plate of FIG. 4.
FIG. 19 is a block diagram illustrating an electronic device according to one or more embodiments of the present disclosure.
FIG. 20 is a view illustrating an example in which the electronic device of FIG. 19 is implemented as a television.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

In the drawings, the relative sizes of elements, layers, and regions may be exaggerated for clarity and/or descriptive purposes. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "upper side," and/or the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Hereinafter, a display device and an electronic device including the same according to embodiments of the present disclosure will be explained in detail with reference to the accompanying drawings. The same reference numerals are used for the same components in the drawings, and redundant descriptions of the same components will be omitted.

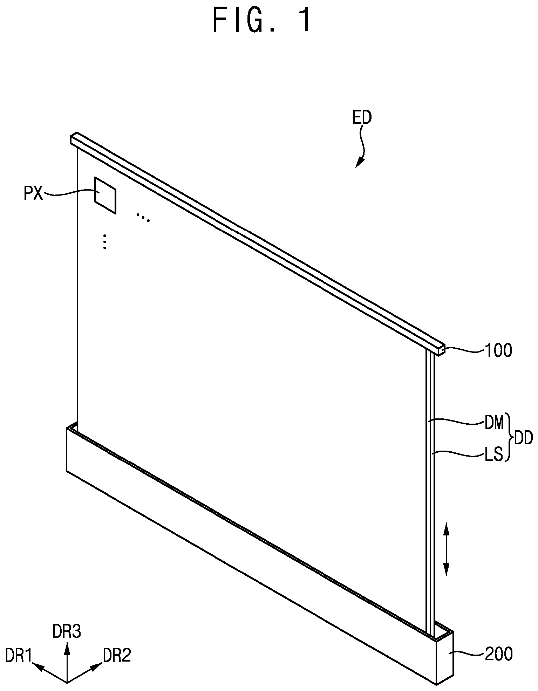

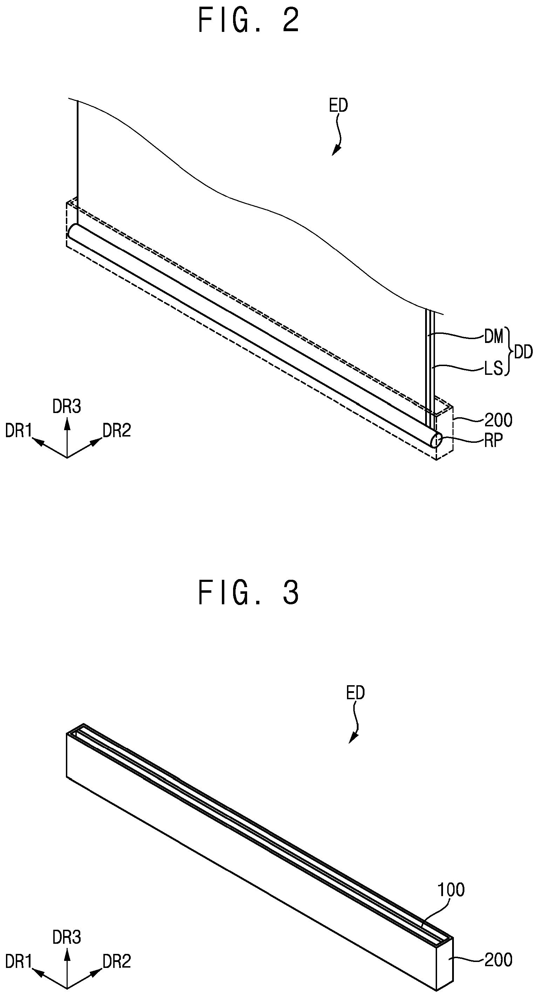

FIG. 1 is a perspective view illustrating an electronic device according to one or more embodiments of the present disclosure. FIG. 2 is a perspective view illustrating a roller located inside an accommodating portion of FIG. 1 and a display device fixed by the roller. FIG. 3 is a perspective view illustrating the display device of FIG. 1 in a rolled state.

In this specification, a plane may be defined as a first direction DR1 and a third direction DR3 crossing the first direction DR1. For example, the first direction DR1 may be perpendicular to the third direction DR3. In addition, a second direction DR2 may be perpendicular to the plane.

Referring to FIGS. 1, 2, and 3, an electronic device ED according to one or more embodiments of the present disclosure may include a display device DD, a fixing bracket 100, an accommodating portion 200, and a roller RP.

The display device DD may include a display module DM and a lower structure LS located under the display module DM. A detailed description of each component of the display module DM and the lower structure LS will be described later.

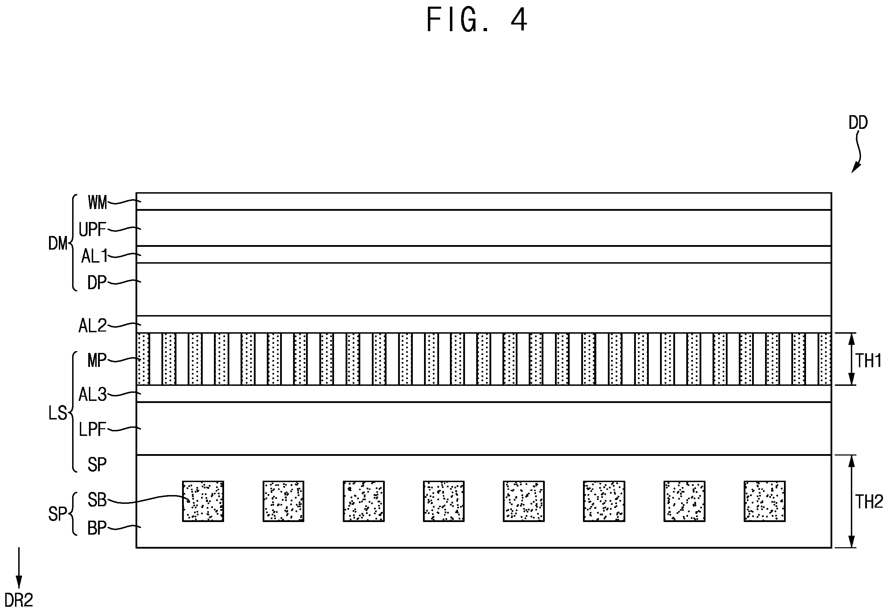

The display module DM may include a display panel (e.g., a display panel DP of FIG. 4) including a plurality of pixels PX. For example, the display panel may include a liquid crystal display panel, an organic light-emitting diode display panel, an inorganic light-emitting diode display panel, or a quantum dot display panel. In one or more embodiments, the display panel may include an organic light-emitting diode display panel. Hereinafter, the description will focus on the case where the display panel is an organic light-emitting diode display panel.

Each of the plurality of pixels PX may include at least one transistor and at least one light-emitting element electrically connected to the transistor. The transistor may generate a driving current, and the light-emitting device may generate light based on the driving current. Accordingly, as each of the plurality of pixels PX emits light, the display module DM may display an image.

The roller RP may be located inside the accommodating portion 200. The roller RP may extend along the first direction DR1. In one or more embodiments, the roller RP may rotate counterclockwise or clockwise base on a rotation axis that passes through a center of the roller RP, and that extends in the first direction DR1.

One end of the display module DM may be fixed to the fixing bracket 100, and the other end of the display module DM may be fixed to the roller RP. In addition, one end of the lower structure LS may be fixed to the fixing bracket 100, and the other end of the lower structure LS may be fixed to the roller RP. The fixing bracket 100 may face the accommodating portion 200 in the third direction DR3.

In one or more embodiments, each of the lower structure LS and the display module DM may have flexibility. Accordingly, the lower structure LS and display module DM may be easily and repeatedly rolled (rolling or winding) or unrolled (unrolling or unwinding) along an outer peripheral surface of the roller RP rotating counterclockwise or clockwise.

For example, when the roller RP rotates counterclockwise, the display device DD may be unrolled as shown in FIGS. 1 and 2. In this case, a part of the display device DD exposed from the accommodating portion 200 may provide a display surface that displays a flat image.

In contrast, when the roller RP rotates clockwise, the display device DD may be rolled as shown in FIG. 3. In this case, at least a part of the rolled display device DD may provide a display surface that displays a curved image. Accordingly, the rolled display device DD may be accommodated in the accommodating portion 200.

FIG. 4 is a cross-sectional view illustrating the display device of FIG. 1.

Referring to FIG. 4, the display device DD may include the lower structure LS, the display module DM, and a second adhesive layer AL2 located between the lower structure LS and the display module DM. Here, the display module DM may include the display panel DP, a first adhesive layer AL1, an upper protective layer UPF, and a window member WM. The lower structure LS may include a metal plate MP, a third adhesive layer AL3, a lower protective layer LPF, and a support plate SP.

The display panel DP may include a plurality of pixels (e.g., the plurality of pixels PX of FIG. 1) that generate light. A detailed description of the components of the display panel DP will be described later.

The upper protective layer UPF may be located on the display panel DP. For example, the upper protective layer UPF may include triacetyl cellulose (TAC). However, embodiments of the present disclosure are not limited thereto.

The first adhesive layer AL1 may be located between the display panel DP and the upper protective layer UPF. The display panel DP and the upper protective layer UPF may be attached to each other through the first adhesive layer AL1. For example, the first adhesive layer AL1 may include an optical clear adhesive (OCA), a pressure sensitive adhesive (PSA), a photocurable resin, or a thermosetting resin. In one or more embodiments, the first adhesive layer AL1 may include a pressure sensitive adhesive.

The window member WM may be located on the upper protective layer UPF. The window member WM may cover an entirety of the outside of the upper protective layer UPF and the display panel DP, and may protect components of the display module DM from external impacts and scratches.

The window member WM may include an optically transparent insulating material. For example, the window member WM may include glass, sapphire, or a polymer material. The window member WM may have a single-layer or multi-layer structure. For example, the window member WM may further include functional layers, such as an anti-fingerprint layer, a phase control layer, a hard coating layer, and/or the like located on an optically transparent substrate.

The second adhesive layer AL2 may be located between the display module DM and the lower structure LS. The display module DM and the lower structure LS may be attached to each other through the second adhesive layer AL2. For example, the second adhesive layer AL2 may include an optically clear adhesive, a pressure-sensitive adhesive, a photocurable resin, or a thermosetting resin. In one or more embodiments, the second adhesive layer AL2 may include a pressure sensitive adhesive.

The metal plate MP may be located under the display panel DP. The metal plate MP may be attached to the display panel DP through the second adhesive layer AL2. In one or more embodiments, the metal plate MP may be patterned over an entire area. A detailed description of the structure of the metal plate MP will be described later.

When patterns included in the metal plate MP are subjected to a tensile force in a corresponding direction, the patterns may have virtually no deformation in a direction crossing the direction in which the tensile force acts. The metal plate MP may improve the impact resistance of the display module DM without reducing the flexibility of the display module DM. In addition, the metal plate MP may protect the display panel DP from external shock. The metal plate MP may improve the surface quality of the display device DD by reducing the surface of the display panel DP from being cluttered or distorted when the display module DM is rolled.

For example, the metal plate MP may include stainless steel (SUS). However, embodiments of the present disclosure are not limited to this, and the metal plate MP may include various metal materials.

The lower protective layer LPF is located under the metal plate MP. For example, the lower protective layer LPF may include thermoplastic polyurethane (TPU). However, embodiments of the present disclosure are not limited thereto.

The support plate SP is located under the lower protective layer LPF. The support plate SP may support the display module DM. The support plate SP may be bent to a curvature (e.g., predetermined curvature). In addition, the support plate SP may support the rolled display module DM and may reduce or prevent deformation of the display module DM. The support plate SP may reduce or prevent deterioration of the surface quality of the display module DM even when the display device DD is repeatedly rolled.

The support plate SP may supplement the rigidity of the display module DM by having a rigidity (e.g., predetermined rigidity). Accordingly, the support plate SP may reduce or prevent damage to the display panel DP due to external shock.

In one or more embodiments, the support plate SP may include a base part BP and a plurality of support bars SB. The base part BP may surround the plurality of support bars SB, which may be impregnated into the base part BP. That is, the plurality of support bars SB may be located inside the base part BP.

The plurality of support bars SB may be repeatedly arranged along one direction (e.g., first direction DR1). For example, the plurality of support bars SB may be arranged at equal intervals from each other along one direction. However, embodiments of the present disclosure are not limited thereto. For example, an interval between the plurality of support bars SB may gradually increase or decrease along one direction.

In one or more embodiments, each of the plurality of support bars SB may have a polygonal shape in a cross-section. For example, each of the plurality of support bars SB may have a quadrangle shape in a cross-section. However, embodiments of the present disclosure are not limited to this, and each of the plurality of support bars SB may have various shapes in a cross-section.

The plurality of support bars SB may have a rigidity (e.g., predetermined rigidity). In one or more embodiments, the plurality of support bars SB may include carbon fiber reinforced plastic (CFRP) or glass fiber reinforced plastic (GFRP). However, embodiments of the present disclosure are not limited thereto.

The base part BP may include an elastic polymer having a flexibility (e.g., predetermined flexibility). In one or more embodiments, the base part BP may include silicone resin. However, embodiments of the present disclosure are not limited thereto.

A first thickness TH1 of the metal plate MP in the second direction DR2 may be different from a second thickness TH2 of the support plate SP in the second direction DR2.

In one or more embodiments, the first thickness TH1 may range from about 0.05 mm to about 0.3 mm. For example, the first thickness TH1 may range from about 0.1 mm to about 0.15 mm. Forming the first thickness TH1 to less than about 0.05 mm may be difficult or impossible due to the process. When the first thickness TH1 is greater than about 0.3 mm, damage may occur to the display panel DP.

In one or more embodiments, the second thickness TH2 may range from about 1.0 mm to about 5.0 mm. For example, the second thickness TH2 may be about 2.0 mm. Forming the second thickness TH2 to less than about 1.0 mm may be difficult or impossible due to the process. When the second thickness TH2 is greater than about 5.0 mm, damage may occur to the display panel DP.

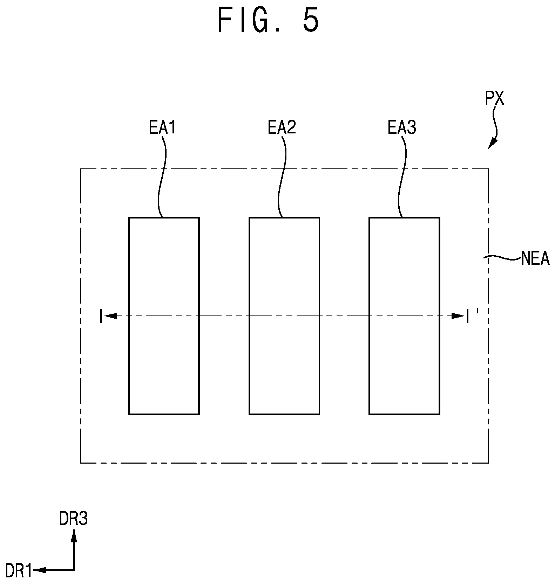

FIG. 5 is a plan view illustrating one pixel of FIG. 1.

Referring to FIG. 5, one pixel PX may include a first light-emitting area EA1, a second light-emitting area EA2, a third light-emitting area EA3, and a non-light-emitting area NEA.

Each of the first light-emitting area EA1, the second light-emitting area EA2, and the third light-emitting area EA3 may be an area where light of a corresponding color generated by the light-emitting element of one pixel PX is emitted to the outside. For example, the first emitting area EA1 may emit light of a first color, the second emitting area EA2 may emit light of a second color, and the third light-emitting area EA3 may emit light of a third color. In one or more embodiments, the first color light may be red light, the second color light may be green light, and the third color light may be blue light. However, embodiments of the present disclosure are not limited thereto. For example, the first light-emitting area EA1, the second light-emitting area EA2, and the third light-emitting area EA3 may be combined to emit yellow, cyan, and magenta lights.

In addition, the first light-emitting area EA1, the second light-emitting area EA2, and the third light-emitting area EA3 may emit light of four or more colors. For example, the first light-emitting area EA1, the second light-emitting area EA2, and the third light-emitting area EA3 may be combined to further emit at least one of yellow, cyan, or magenta lights in addition to red, green, and blue lights. In addition, the first light-emitting area EA1, the second light-emitting area EA2, and the third light-emitting area EA3 may be combined to emit more white light.

The non-light-emitting area NEA may be located between the first light-emitting area EA1, the second light-emitting area EA2, and the third light-emitting area EA3. The non- light-emitting area NEA may not emit light.

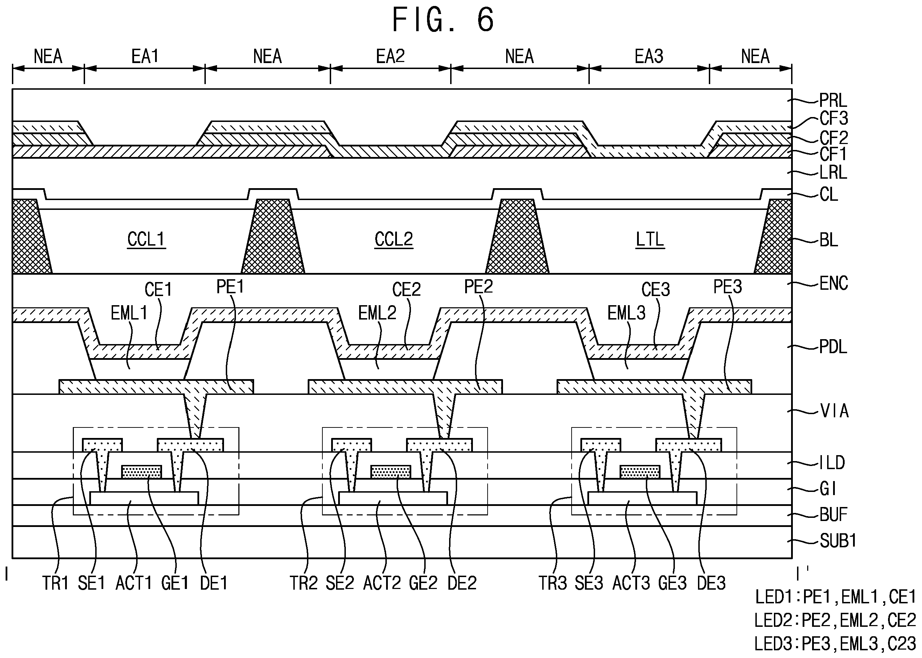

FIG. 6 is a cross-sectional view taken along the line I-I' of FIG. 5.

Referring to FIG. 6, the display panel DP may include a substrate SUB, a buffer layer BUF, first, second, and third transistors TR1, TR2, and TR3, a gate-insulating layer GI, an interlayer insulating layer ILD, a via insulating layer VIA, a pixel-defining layer PDL, first, second, and third light-emitting elements LED1, LED2, and LED3, an encapsulation layer ENC, a bank layer BL, a wavelength conversion layer, a capping layer CL, a low refractive index layer LRL, a color filter layer, and a protective layer PRL.

The first transistor TR1 may include a first active pattern ACT1, a first gate electrode GE1, a first source electrode SE1, and a first drain electrode DE1, the second transistor TR2 may include a second active pattern ACT2, a second gate electrode GE2, a second source electrode SE2, and a second drain electrode DE2, and the third transistor TR3 may include a third active pattern ACT3, a third gate electrode GE3, a third source electrode SE3, and a third drain electrode DE3.

In addition, the first light-emitting element LED1 may include a first pixel electrode PE1, a first light-emitting layer EML1, and a first common electrode CE1, the second light-emitting element LED2 may include a second pixel electrode PE2, a second light-emitting layer EML2, and a second common electrode CE2, and the third light-emitting element LED3 may include a third pixel electrode PE3, a third light-emitting layer EML3, and a third common electrode CE3.

The substrate SUB may include a transparent material or an opaque material. The substrate SUB may be made of a transparent resin substrate. Examples of the transparent resin substrate may include a polyimide substrate. In this case, the polyimide substrate may include a first organic layer, a first barrier layer, a second organic layer, and/or the like. Alternatively, the substrate SUB may include a quartz substrate, synthetic quartz substrate, calcium fluoride substrate, F-doped quartz substrate, a soda-lime glass substrate, a non-alkali glass substrate, and/or the like. These can be used alone or in combination with each other.

The buffer layer BUF may be located on the substrate SUB. The buffer layer BUF may reduce or prevent metal atoms or impurities diffusing from the substrate SUB to the first, second, and third transistors TR1, TR2, and TR3. In addition, the buffer layer BUF may improve the flatness of the surface of the substrate SUB when the surface of the substrate SUB is not uniform. For example, the buffer layer BUF may include an inorganic material, such as silicon oxide, silicon nitride, silicon oxynitride, and/or the like. These can be used alone or in combination with each other.

The first, second, and third active patterns ACT1, ACT2, and ACT3 may be located on the buffer layer BUF. Each of the first, second, and third active patterns ACT1, ACT2, and ACT3 may include a metal oxide semiconductor, an inorganic semiconductor (e.g., amorphous silicon, poly silicon), or an organic semiconductor. Each of the first, second, and third active patterns ACT1, ACT2, and ACT3 may include a source region, a drain region, and a channel region located between the source region and the drain region. The first, second, and third active patterns ACT1, ACT2, and ACT3 may be formed through the same process and may include the same material.

The metal oxide semiconductor may include a binary compound (ABₓ), a ternary compound (ABₓC_{y}), a quaternary compound (ABₓC_{y}D_{z}), and/or the like containing indium (In), zinc (Zn), gallium (Ga), tin (Sn), titanium (Ti), aluminum (Al), hafnium (Hf), zirconium (Zr), magnesium (Mg), and/or the like. For example, the metal oxide semiconductor may include zinc oxide (ZnOₓ), gallium oxide (GaOₓ), tin oxide (SnOₓ), indium oxide (InOₓ), indium gallium oxide (IGO), indium zinc oxide (IZO), indium tin oxide. (ITO), indium zinc tin oxide (IZTO), indium gallium zinc oxide (IGZO), and/or the like. These can be used alone or in combination with each other.

The gate-insulating layer GI may be located on the buffer layer BUF. The gate-insulating layer GI may sufficiently cover the first, second, and third active patterns ACT1, ACT2, and ACT3, and may have a substantially flat upper surface without creating a step around the first, second, and third active patterns ACT1, ACT2, and ACT3. Alternatively, the gate-insulating layer GI may cover the first, second, and third active patterns ACT1, ACT2, and ACT3, and may be located along the profile of each of the first, second, and third active patterns ACT1, ACT2, and ACT3 with a substantially uniform thickness. For example, the gate-insulating layer GI may include an inorganic material, such as silicon oxide (SiOₓ), silicon nitride (SiNₓ), silicon carbide (SiCₓ), silicon oxynitride (SiOₓN_{y}), silicon oxycarbide (SiOₓC_{y}), and/or the like. These can be used alone or in combination with each other.

The first, second, and third gate electrodes GE1, GE2, and GE3 may be located on the gate-insulating layer GI. The first gate electrode GE1 may overlap the channel area of the first active pattern ACT1, the second gate electrode GE2 may overlap the channel area of the second active pattern ACT2, and the third gate electrode GE3 may overlap the channel area of the third active pattern ACT3.

Each of the first, second, and third gate electrodes GE1, GE2, and GE3 may include metal, alloy metal nitride, conductive metal oxide, transparent conductive material, and/or the like. Examples of the metal may include silver (Ag), molybdenum (Mo), aluminum (Al), tungsten (W), copper (Cu), nickel (Ni), chromium (Cr), titanium (Ti), tantalum (Ta), platinum (Pt), scandium (Sc), and/or the like. Examples of the conductive metal oxide may include indium tin oxide and indium zinc oxide. In addition, examples of the metal nitride may include aluminum nitride (AlNₓ), tungsten nitride (WNₓ), chromium nitride (CrNₓ), and/or the like. These can be used alone or in combination with each other.

The first, second, and third gate electrodes GE1, GE2, and GE3 may be formed through the same process and may include the same material.

The interlayer insulating layer ILD may be located on the gate-insulating layer GI. The interlayer insulating layer ILD may sufficiently cover the first, second, and third gate electrodes GE1, GE2, and GE3 and may have a substantially flat upper surface without creating a step around the first, second, and third gate electrodes GE1, GE2, and GE3. Alternatively, the interlayer insulating layer ILD may cover the first, second, and third gate electrodes GE1, GE2, and GE3, and may be located along the profile of each of the first, second, and third gate electrodes GE1, GE2, and GE3 with a substantially uniform thickness. For example, the interlayer dielectric layer ILD may include an inorganic material, such as silicon oxide, silicon nitride, silicon carbide, silicon oxynitride, silicon oxycarbide, and/or the like. These can be used alone or in combination with each other.

The first, second, and third source electrodes SE1, SE2, and SE3 may be located on the interlayer insulating layer ILD. The first source electrode SE1 may be connected to the source region of the first active pattern ACT1 through a contact hole penetrating the gate-insulating layer GI and the interlayer insulating layer ILD. The second source electrode SE2 may be connected to the source region of the second active pattern ACT2 through a contact hole penetrating the gate-insulating layer GI and the interlayer insulating layer ILD. The third source electrode SE3 may be connected to the source region of the third active pattern ACT3 through a contact hole penetrating the gate-insulating layer GI and the interlayer insulating layer ILD.

The first, second, and third drain electrodes DE1, DE2, and DE3 may be located on the interlayer insulating layer ILD. The first drain electrode DE1 may be connected to the drain region of the first active pattern ACT1 through a contact hole penetrating the gate-insulating layer GI and the interlayer insulating layer ILD. The second drain electrode DE2 may be connected to the drain region of the second active pattern ACT2 through a contact hole penetrating the gate-insulating layer GI and the interlayer insulating layer ILD. The third drain electrode DE3 may be connected to the drain region of the third active pattern ACT3 through a contact hole penetrating the gate-insulating layer GI and the interlayer insulating layer ILD.

For example, each of the first, second, and third source electrodes SE1, SE2, and SE3 may include metal, alloy, metal nitride, conductive metal oxide, transparent conductive material, and/or the like. These can be used alone or in combination with each other. The first, second, and third drain electrodes DE1, DE2, and DE3 may be formed through the same process as the first, second, and third source electrodes SE1, SE2, and SE3, and may include the same material.

The via insulating layer VIA may be located on the interlayer insulating layer ILD. The via insulating layer VIA may sufficiently cover the first, second, and third source electrodes SE1, SE2, and SE3 and the first, second, and third drain electrodes DE1, DE2, and DE3. The via insulating layer VIA may include an organic material. For example, the via insulation layer VIA may include an organic material, such as phenolic resin, polyacrylates resin, polyimides resin, polyamides resin, siloxane resin, epoxy resin, and/or the like. These can be used alone or in combination with each other.

The first, second, and third pixel electrodes PE1, PE2, and PE3 may be located on the via insulating layer VIA. The first pixel electrode PE1 may overlap the first light-emitting area EA1, the second pixel electrode PE2 may overlap the second light-emitting area EA2, and the third pixel electrode PE3 may overlap the third light-emitting area EA3. The first pixel electrode PE1 may be connected to the first drain electrode DE1 through a contact hole penetrating the via insulating layer VIA, the second pixel electrode PE2 may be connected to the second drain electrode DE2 through a contact hole penetrating the via insulating layer VIA, and the third pixel electrode PE3 may be connected to the third drain electrode DE3 through a contact hole penetrating the via insulating layer VIA.

For example, each of the first, second, and third pixel electrodes PE1, PE2, and PE3 may include metal, alloy, metal nitride, conductive metal oxide, transparent conductive material, and/or the like. These can be used alone or in combination with each other. In one or more embodiments, each of the first, second, and third pixel electrodes PE1, PE2, and PE3 may have a stacked structure including ITO/Ag/ITO. The first, second, and third pixel electrodes PE1, PE2, and PE3 may be formed through the same process and may include the same material. For example, each of the first, second, and third pixel electrodes PE1, PE2, and PE3 may operate as an anode.

The pixel-defining layer PDL may be located on the via insulating layer VIA. The pixel-defining layer PDL may overlap the non-light-emitting area NEA. The pixel-defining layer PDL may cover the edges of each of the first, second, and third pixel electrodes PE1, PE2, and PE3. In addition, a pixel opening exposing at least a part of the upper surface of each of the first, second, and third pixel electrodes PE1, PE2, and PE3 may be defined in the pixel-defining layer PDL. For example, the pixel-defining layer PDL may include an inorganic material and/or an organic material. In one or more embodiments, the pixel-defining layer PDL may include an organic material, such as epoxy resin, siloxane resin, and/or the like. These can be used alone or in combination with each other. In one or more other embodiments, the pixel-defining layer PDL may include an organic material containing a light-blocking material, such as black pigment, black dye, and/or the like.

The first light-emitting layer EML1 may be located on the first pixel electrode PE1, the second light-emitting layer EML2 may be located on the second pixel electrode PE2, and the third light-emitting layer EML3 may be located on the third pixel electrode PE3. That is, the first light-emitting layer EML1 may overlap the first light-emitting area EA1, the second light-emitting layer EML2 may overlap the second light-emitting area EA2, and the third light-emitting layer EML3 may overlap the third light-emitting area EA3.

Each of the first, second, and third light-emitting layers EML1, EML2, and EML3 may include a light-emitting material that generates light of a suitable color (e.g., preset color). In one or more embodiments, each of the first, second, and third light-emitting layers EML1, EML2, and EML3 may include a light-emitting material that generates blue light.

The first common electrode CE1 may be located on the first light-emitting layer EML1 and the pixel-defining layer PDL, the second common electrode CE2 may be located on the second emitting layer EML2 and the pixel-defining layer PDL, and the third common electrode CE3 may be located on the third emitting layer EML3 and the pixel-defining layer PDL. The first, second, and third common electrodes CE1, CE2, and CE3 may be formed integrally. For example, each of the first, second, and third common electrodes CE1, CE2, and CE3 may include metal, alloy, metal nitride, conductive metal oxide, transparent conductive material, and/or the like. These can be used alone or in combination with each other. The first, second, and third common electrodes CE1, CE2, and CE3 may operate as cathodes.

The first light-emitting element LED1 may be electrically connected to the first transistor TR1, the second light-emitting element LED2 may be electrically connected to the second transistor TR2, and the third light-emitting element LED3 may be electrically connected to the third transistor TR3.

The encapsulation layer ENC may be located on the first, second, and third common electrodes CE1, CE2, and CE3. The encapsulation layer ENC may reduce or prevent impurities, moisture, external air, and/or the like penetrating into the first, second, and third light-emitting elements LED1, LED2, and LED3 from the outside. The encapsulation layer ENC may include at least one inorganic layer and at least one organic layer. For example, the inorganic layer may include silicon oxide, silicon nitride, silicon oxynitride, and/or the like. These can be used alone or in combination with each other. The organic layer may include a cured polymer, such as polyacrylate and/or the like.

The bank layer BL may be located on the encapsulation layer ENC. The bank layer BL may overlap the non-light-emitting area NEA. An opening that accommodates the ink composition, which is a material for forming the wavelength conversion layer, may be defined in the bank layer BL. For example, the bank layer BL may have a lattice shape in a plan view. However, embodiments of the present disclosure are not limited thereto.

For example, the bank layer BL may include an organic material, such as polyimide. Alternatively, the bank layer BL may include an organic material containing a light-blocking material. In this case, a color of the bank layer BL may be black.

The wavelength conversion layer may be located on the encapsulation layer ENC. The wavelength change layer may convert the wavelength of light emitted from the first, second, and third light-emitting elements LED1, LED2, and LED3. The wavelength conversion layer may include a first color conversion layer CCL1, a second color conversion layer CCL2, and a light transmission layer LTL.

The first color conversion layer CCL1 may overlap the first light-emitting area EA1. The first color conversion layer CCL1 may include first quantum dots that are excited by the first light (e.g., the blue light) emitted from the first light-emitting element LED1 and that emit light of the first color (e.g., the red light). In addition, the first color conversion layer CCL1 may further include a first base resin in which first scattering particles are dispersed.

The second color conversion layer CCL2 may overlap the second light-emitting area EA2. The second color conversion layer CCL2 may include second quantum dots that are excited by the first light (e.g., the blue light) emitted from the second light-emitting element LED2 and that emit light of the second color (e.g., the green light). In addition, the second color conversion layer CCL2 may further include a second base resin in which second scattering particles are dispersed.

The light transmission layer LTL may overlap the third light-emitting area EA3. The light transmitting layer may emit blue light by transmitting the first light (e.g., the blue light) emitted from the third light-emitting element LED3. In addition, the light transmission layer LTL may include a third base resin in which third scattering particles are dispersed.

For example, each of the first, second, and third base resins may include a resin with high light transparency, such as photoresist, silicone resin, epoxy resin, and/or the like. These can be used alone or in combination with each other.

For example, the first, second, and third scattering particles may scatter and may emit light emitted from the first, second, and third light-emitting elements LED1, LED2, and LED3, respectively. In addition, the first, second, and third scattering particles may include the same material as each other.

Accordingly, the first light-emitting area EA1 may emit red light, the second light-emitting area EA2 may emit green light, and the third light-emitting area EA3 may emit blue light.

The capping layer CL may be located on the wavelength conversion layer and the bank layer BL. The capping layer CL may be located along the profile of each of the bank layer BL and the wavelength conversion layer. The capping layer CL may serve to reduce or prevent moisture permeation to thereby reduce or prevent deterioration of the wavelength conversion layer. For example, the capping layer CL may include an inorganic material, such as silicon oxide, silicon nitride, silicon oxynitride, and/or the like. These can be used alone or in combination with each other.

The low refractive index layer LRL may be located on the capping layer CL. The low refractive layer LRL may have a relatively low refractive index. For example, the refractive index of the low refractive layer LRL may be lower than the refractive index of each of the first color conversion layer CCL1, the second color conversion layer CCL2, and the light transmission layer LTL. The low refractive index layer LRL may include an organic material. For example, the low refractive index layer LRL may include an organic polymer material including silicon.

The color filter layer may be located on the low refractive index layer LRL. The color filter layer may selectively transmit light having a corresponding wavelength. The color filter layer may include a first color filter CF1, a second color filter CF2, and a third color filter CF3.

The first color filter CF1 may selectively transmit first color light (e.g., the red light). The first color filter CF1 may overlap the first light-emitting area EA1 and the non-light-emitting area NEA. In this case, the first color filter CF1 may not overlap the second and third light-emitting areas EA2 and EA3.

The second color filter CF2 may selectively transmit second color light (e.g., the green light). The second color filter CF2 may overlap the second light-emitting area EA2 and the non-light-emitting area NEA. In this case, the second color filter CF2 may not overlap the first and third light-emitting areas EA1 and EA3.

In one or more embodiments, a light-blocking layer may be formed in the non-light-emitting area NEA by overlapping and stacking the first, second, and third color filters CF1, CF2, and CF3. That is, in the non-light-emitting area NEA, the light-blocking layer may be formed by overlapping and stacking the first, second, and third color filters CF1, CF2, and CF3 without forming a separate light-blocking layer.

The protective layer PRL may be located on the first color filter CF1, the second color filter CF2, and the third color filter CF3. The protective layer PRL may cover the first color filter CF1, the second color filter CF2, and the third color filter CF3. The protective layer PRL may include inorganic and/or organic materials. For example, the protective layer PRL may include silicon oxide, silicon nitride, silicon oxynitride, and/or the like. These can be used alone or in combination with each other.

In one or more embodiments, unlike shown in FIG. 6, the display panel DP may be divided into a first substrate including a transistor, a light-emitting element, and a wavelength conversion layer, and a second substrate including a color filter layer. In this case, the first substrate and the second substrate may be manufactured separately and bonded together. However, embodiments of the present disclosure are not limited thereto.

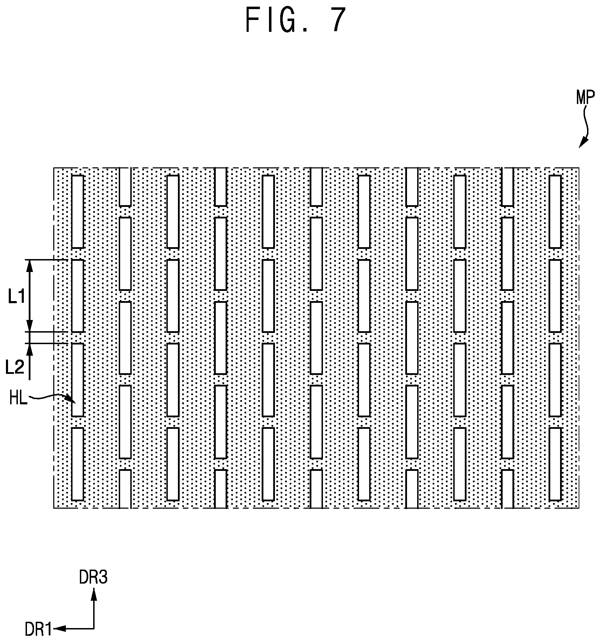

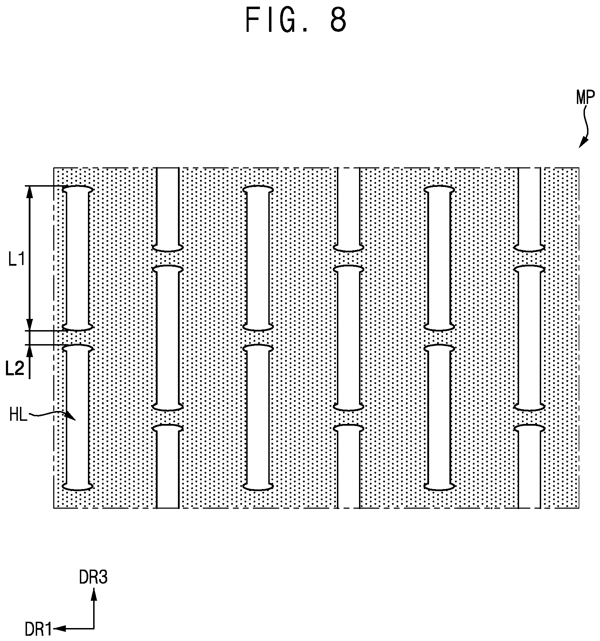

FIGS. 7 and 8 are plan views illustrating examples of a metal plate of FIG. 4.

Referring to FIGS. 7 and 8, a plurality of openings HL may be defined in the metal plate MP. In one or more embodiments, the metal plate MP may have a lattice shape in a plan view. However, embodiments of the present disclosure are not limited thereto.

Each of the plurality of openings HL may extend in the third direction DR3. That is, a long axis of each of the plurality of openings HL may be parallel to the third direction DR3.

The plurality of openings HL may have the same planar shape. For example, as shown in FIG. 7, each of the plurality of openings HL may have a rectangular planar shape. Alternatively, as shown in FIG. 8, each of the plurality of openings HL may have the planar shape of a dumbbell. However, embodiments of the present disclosure are not limited to this, and the shape and size of each of the plurality of openings HL may vary.

Each of the plurality of openings HL may have a length (e.g., predetermined length) L1. In addition, the plurality of openings HL arranged in the same row may be spaced apart by an interval (e.g., predetermined interval) L2. The plurality of openings HL arranged in the same row may be located in parallel to, and/or misaligned with, the plurality of openings HL arranged in another adjacent row.

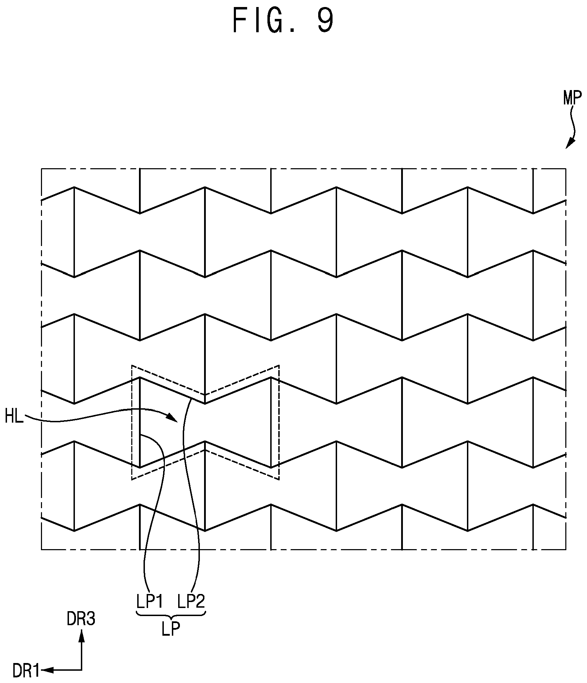

FIGS. 9, 10, 11, 12, 13, 14, and 15 are plan views illustrating other examples of a metal plate of FIG. 4.

Referring to FIGS. 9, 10, 11, 12, 13, 14, and 15, in one or more embodiments, the metal plate MP may include an auxetic structure. For example, the auxetic structure may have a negative Poisson's ratio that allows stretching in a biaxial direction. The auxetic structure may include a plurality of patterns LP connected to each other.

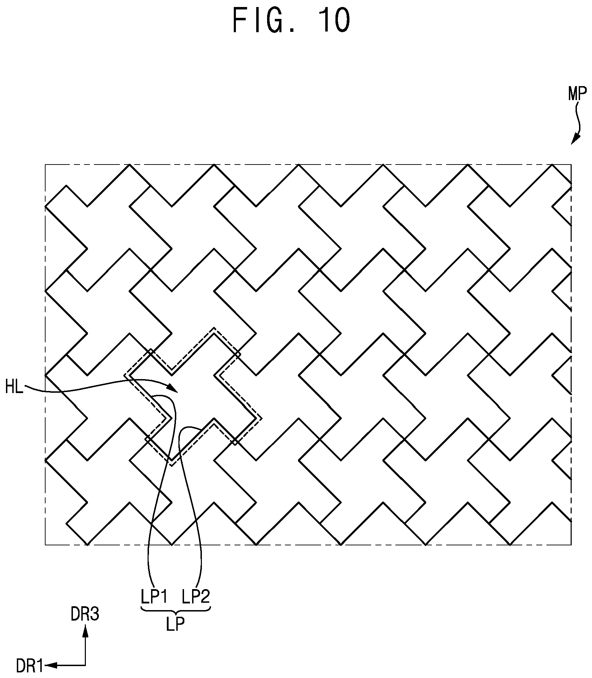

Referring to FIGS. 9 and 10, each of the plurality of patterns LP may include first line parts LP1 and second line parts LP2. Each of the first line parts LP1 may extend generally in the third direction DR3, and each of the second line parts LP2 may extend generally in the first direction DR1. Each of the first line parts LP1 may be located between two adjacent second line parts LP2 in the third direction DR3.

Each of the plurality of patterns LP may have a closed line shape in a plan view due to the first line parts LP1 and the second line parts LP2. In addition, an opening HL may be defined between the first line parts LP1 and the second line parts LP2. That is, the auxetic structure of the metal plate MP may include the plurality of openings HL surrounded by closed line shapes connected to each other.

One pattern among the plurality of patterns LP may be connected to patterns LP located adjacent to the one pattern while engaging with each other. The plurality of patterns LP may have the same planar shape.

As shown in FIG. 9, the planar shape of each of the plurality of patterns LP may have two reentering angles. Alternatively, as shown in FIG. 10, each of the plurality of patterns LP may have a planar shape similar to a pinwheel.

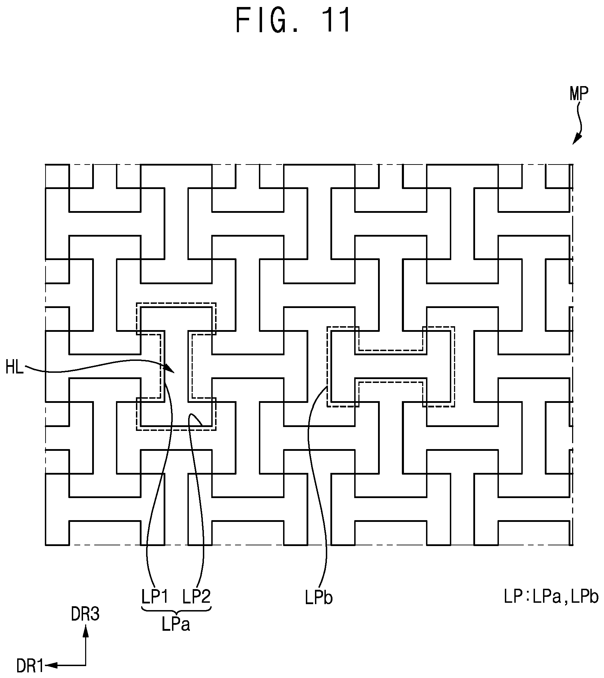

Referring to FIG. 11, each of the plurality of patterns LP may include first line parts LP1 and second line parts LP2. Each of the first line parts LP1 may extend in the third direction DR3, and each of the second line parts LP2 may extend in the first direction DR1.

Each of the plurality of patterns LP may have a closed line shape in a plan view due to the first line parts LP1 and the second line parts LP2. In addition, an opening HL may be defined between the first line parts LP1 and the second line parts LP2. That is, the auxetic structure of the metal plate MP may include the plurality of openings HL surrounded by closed line shapes connected to each other.

One pattern LPa among the plurality of patterns LP may be connected to four patterns LPb located adjacent to the one pattern LPa while engaging with each other. The patterns LPa among the plurality of patterns LP may have the same planar shape. The patterns LPb among the plurality of patterns LP may have the same planar shape, and each of the patterns LPb may have a planar shape obtained by rotating the pattern LPa by 90 degrees. For example, each of the patterns LPa may have a dumbbell shape.

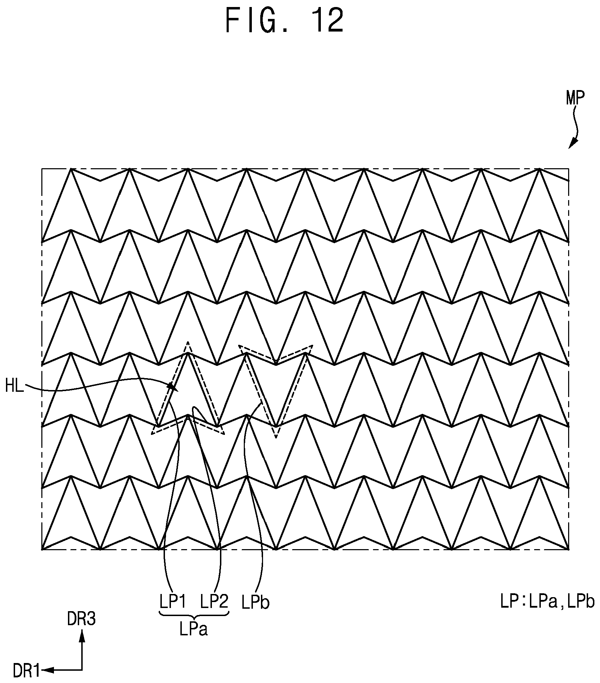

Referring to FIG. 12, each of the plurality of patterns LP may include first line parts LP1 and second line parts LP2. Each of the first line parts LP1 may extend generally in the third direction DR3, and each of the second line parts LP2 may extend generally in the first direction DR1.

Each of the plurality of patterns LP may have a closed line shape in a plan view due to the first line parts LP1 and the second line parts LP2. In addition, an opening HL may be defined between the first line parts LP1 and the second line parts LP2. That is, the auxetic structure of the metal plate MP may include the plurality of openings HL surrounded by closed line shapes connected to each other.

One pattern LPa Among the plurality of patterns LP may be alternately arranged in the first direction DR1 with the pattern LPb located adjacent to the one pattern LPa. The patterns LPa among the plurality of patterns LP may have the same planar shape. The patterns LPb among the plurality of patterns LP may have the same planar shape, and each of the patterns LPb may have a planar shape obtained by rotating the pattern LPa by 180 degrees. For example, the planar shape of each of the patterns LPa may have one reentrant angle.

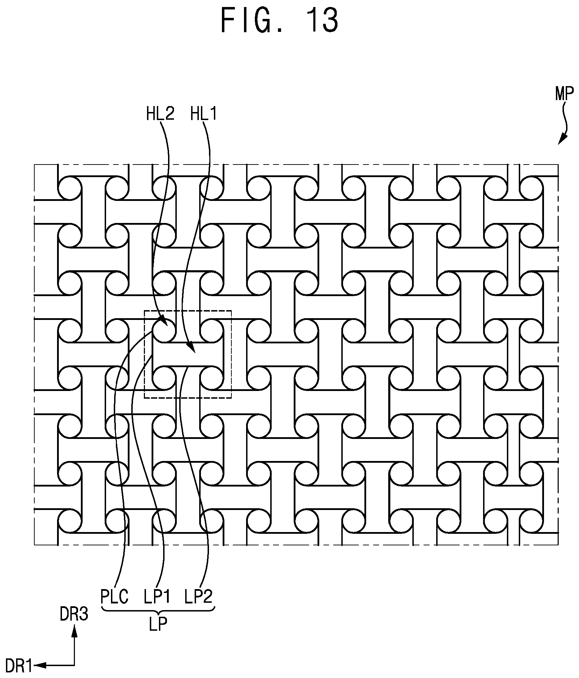

Referring to FIG. 13, each of the plurality of patterns LP may include a closed line pattern PLC and first line parts LP1 and second line parts LP2 extending from the closed line pattern PLC and spaced apart from each other. Each of the first line parts LP1 may extend in the third direction DR3, and each of the second line parts LP2 may extend in the first direction DR1.

For example, the closed line pattern PLC may have a circular planar shape. However, embodiments of the present disclosure are not limited thereto. A second opening HL2 may be defined by the closed line pattern PLC. That is, the auxetic structure of the metal plate MP may include the plurality of second openings HL2 by the closed line pattern PLC.

A first opening HL1 may be defined between the closed line patterns PLC, the first line parts LP1, and the second line parts LP2. That is, the auxetic structure of the metal plate MP may further include the plurality of first openings HL1 by the closed line patterns PLC, the first line parts LP1, and the second line parts LP2.

For example, each of the plurality of patterns LP may include two first line parts LP1, two second line parts LP2, and four closed line patterns PLC. In this case, each of the first line parts LP1 may connect two adjacent closed line patterns PLC, and each of the second line parts LP2 may connect two adjacent closed line patterns PLC.

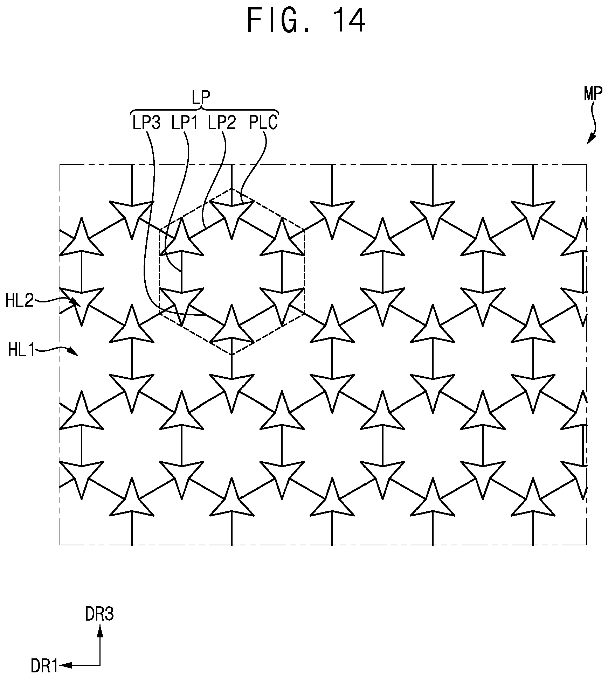

Referring to FIG. 14, each of the plurality of patterns LP may include a closed line pattern PLC and first, second, and third line parts LP1, LP2, and LP3 extending from the closed line pattern PLC and spaced apart from each other. Each of the first line parts LP1 may extend in the third direction DR3, and each of the second line parts LP2 may extend in a direction inclined at an angle (e.g., predetermined angle) to the right of the third direction DR3. In addition, each of the third line parts LP3 may extend in a direction inclined at an angle (e.g., predetermined angle) to the left of the third direction DR3.

For example, the planar shape of a closed line pattern PLC may have three reentrant angles. However, embodiments of the present disclosure are not limited thereto. A second opening HL2 may be defined by the closed line pattern PLC. That is, the auxetic structure of the metal plate MP may include the plurality of second openings HL2 by the closed line pattern PLC.

A first opening HL1 may be defined between the closed line patterns PLC and the first, second, and third line portions LP1, LP2, and LP3. That is, the auxetic structure of the metal plate MP may further include the plurality of first openings HL1 obtained by the closed line patterns PLC and the first, second, and third line parts LP1, LP2, and LP3.

For example, each of the plurality of patterns LP may include two first line parts LP1, two second line parts LP2, two third line parts LP3, and six closed lines PLC. In this case, each of the first line parts LP1 may connect concave parts of two adjacent closed line patterns PLC, and each of the second line parts LP2 may connect concave parts of two adjacent closed line patterns PLC. Each of the third line parts LP3 may connect concave parts of the two adjacent closed line patterns PLC.

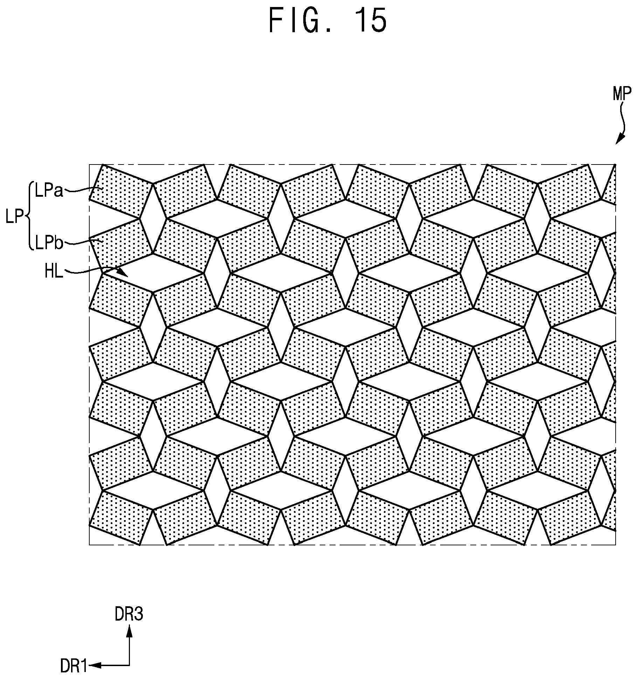

Referring to FIG. 15, the metal plate MP may include a plurality of patterns LP. The plurality of patterns LP may include a plurality of first patterns LPa and a plurality of second patterns LPb.

Each of the first patterns LPa may extend in a direction inclined at an angle (e.g., predetermined angle) to the left of the third direction DR3. Each of the second patterns LPb may extend in a direction inclined at an angle (e.g., predetermined angle) to the right of the third direction DR3.

An opening HL may be defined between the first patterns LPa and the second patterns LPb. That is, the auxetic structure of the metal plate MP may include the plurality of openings HL by the first patterns LPa and the second patterns LPb connected to each other.

For example, the first patterns LPa and the second patterns LPb may be alternately arranged in the first direction DR1. The first patterns LPa may have the same planar shape. The second patterns LPb may have the same planar shape, and each of the second patterns LPb may have a planar shape obtained by rotating the first pattern LPa by 45 degrees. For example, each of the first patterns LPa may have a quadrangle planar shape.

However, embodiments of the present disclosure are not limited to this, and the metal plate MP may include the auxetic structure having various shapes.

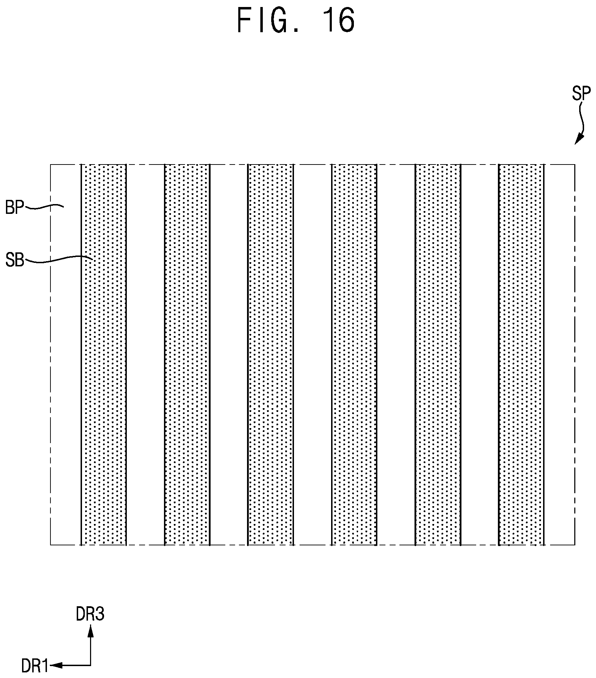

FIG. 16 is a plan view illustrating a support plate of FIG. 4.

Referring to FIGS. 4 and 16, the plurality of support bars SB of the support plate SP may be repeatedly arranged along the first direction DR1. In one or more embodiments, each of the plurality of support bars SB may extend in a horizontal direction parallel to an upper surface of the display module DM (e.g., the third direction DR3). That is, each of the plurality of support bars SB may have a bar shape extending in the third direction DR3.

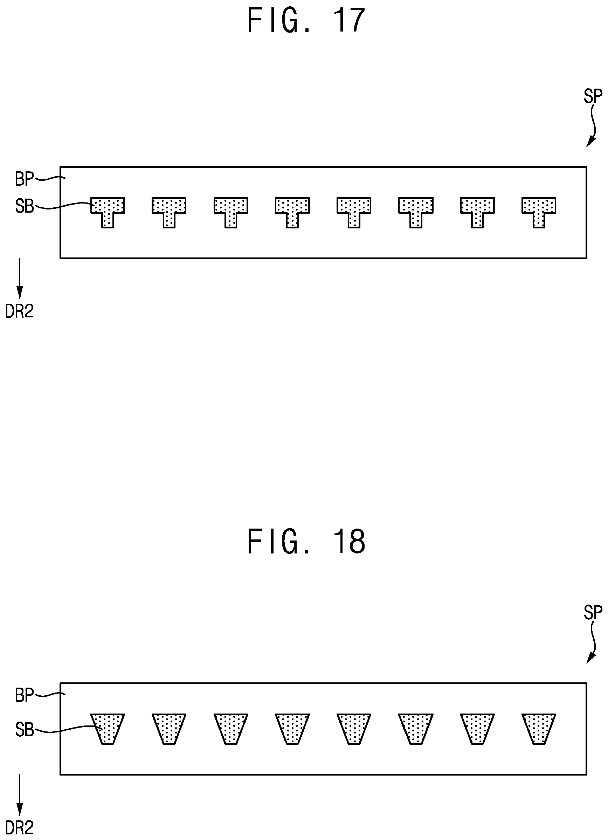

FIGS. 17 and 18 are cross-sectional views illustrating examples of a support plate of FIG. 4.

Referring to FIGS. 17 and 18, as described above, each of the plurality of support bars SB of the support plate may have a polygonal shape in a cross-section. For example, as shown in FIG. 17, each of the plurality of support bars SB may have a T-shape in a cross-section. Alternatively, as shown in FIG. 18, each of the plurality of support bars SB may have a trapezoidal shape in a cross-section.

The display device DD according to one or more embodiments of the present disclosure may include the display module DM having flexibility, the metal plate MP located under the display module DM and patterned, and the support plate SP located under the metal plate MP and including the base part BP and the plurality of support bars SB surrounded by the base part BP and each extending in a direction parallel to the display module DM. The display device DD may be fixed to the roller RP and may be rolled or unrolled as the roller RP rotates. Accordingly, the flexibility and rigidity of the display device DD may be secured at the same time.

Hereinafter, the effects of the present disclosure according to comparative examples and embodiments will be described.

As shown in Table 1 below, a rolling display device was manufactured with a radius of curvature of 50R according to Comparative Examples and Embodiments. The thickness of each of the components of the display device (e.g., functional layers, an upper protective layer, a display panel, a metal plate, a lower protective layer, a support plate, and first, second, and third adhesive layers) is listed in Table 1 below.

In Comparative Example 1, Comparative Example 2, Comparative Example 3 and Embodiment 1, the functional layers include an anti-fingerprint layer and a hard coating layer. The upper protective layer was formed using TAC. The display panel includes a substrate including glass, a wavelength conversion layer formed on the substrate, and a color filter layer formed on the wavelength conversion layer. The metal plate was formed using SUS. The lower protective layer was formed using TPU. The support plate was formed by impregnating silicone resin with CFRP to form a base part including silicone resin and a plurality of support bars surrounded by the base part and including CFRP. The first, second, and third adhesive layers were formed using PSA.

However, in Comparative Examples 1 and 2, the display device does not include the metal plate and the third adhesive layer. In addition, in Comparative Example 3, the metal plate was formed without patterning, and in Embodiment 1, the metal plate was formed by patterning.

In addition, in Comparative Example 1, the thickness of a first part between the support bar of the support plate and the upper surface of the base part was 1000 µm, the thickness of the second part between the support bar of the support plate and the lower surface of the base part was 1000 µm, and the thickness of the support bar was 3000 µm. In addition, the support bar had a quadrangle shape in a cross-section and had a width of 4 mm.

In Comparative Example 2, Comparative Example 3, and Embodiment 1, the thickness of a first part between the support bar of the support plate and the upper surface of the base part was 500 µm, the thickness of a second part between the support bar of the support plate and the lower surface of the base part was 500 µm, and the thickness of the support bar was 1000 µm. In addition, the support bar had a T-shape in a cross-section, and the upper width was 1 mm, and the lower width was 0.5 mm.

The display device satisfying Embodiment 1 corresponds to the display device DD of FIGS. 1, 2, 3, and 4.

**Table 1**

| | Comparative Example 1 | Comparative Example 2 | Comparative Example 3 | Embodiment 1 |
|---|---|---|---|---|
| A thickness of the functional layers | 12µm | 12µm | 12µm | 12µm |
| A thickness of the upper protective layer | 60µm | 60µm | 60µm | 60µm |
| A thickness of the first adhesive layer | 25µm | 25µm | 25µm | 25µm |
| A thickness of the display panel | 135µm | 135µm | 135µm | 135µm |
| A thickness of the second adhesive layer | 25µm | 25µm | 25µm | 25µm |
| A thickness of the metal plate | -- | -- | 100µm | 100µm |
| A thickness of the third adhesive layer | -- | -- | 75µm | 75µm |
| A thickness of the lower protective layer | 100µm | 100µm | 100µm | 100µm |
| A thickness of the support plate | 5000µm | 2000µm | 2000µm | 2000µm |

According to Comparative Example 1, Comparative Example 2, Comparative Example 3, and Embodiment 1, the stress and PSA shear stress applied to the glass included in the display panel were measured, and a tensile evaluation was performed on the support plate.

As a result, referring to Table 2 below, it can be confirmed that in Comparative Example 2, the maximum stress applied to the glass included in the display panel was reduced, and the PSA shear stress was reduced, as compared to Comparative Example 1. However, as a result of tensile evaluation of the support plate, it can be confirmed that the support plate was broken.

In Comparative Example 3, it can be confirmed that the maximum stress applied to the glass included in the display panel was reduced, and the PSA shear stress was increased, as compared to Comparative Example 2. In this case, as a result of tensile evaluation of the support plate, it can be confirmed that the support plate is not broken. However, it can be confirmed that buckling occurs in the display panel.

Embodiment 1 can be confirmed to have similar maximum stress applied to the glass included in the display panel, and similar PSA shear stress, as compared to Comparative Example 2. In this case, as a result of tensile evaluation of the support plate, it can be confirmed that the support plate is not broken. In addition, it can be confirmed that buckling occurring in the display panel has been improved.

**Table 2**

| | Comparative Example 1 | Comparative Example 2 | Comparative Example 3 | Embodiment 1 |
|---|---|---|---|---|
| Glass stress (Mpa) | -40 to 228 | 87 to 93 | -44 to 56 | 87 to 94 |
| PSA shear stress (%) | 766 | 281 | 866 | 329 |

As shown in Table 3 below, a rolling display device was manufactured with a radius of curvature of 50R according to Comparative Examples. The thickness of each of the components of the display device (e.g., functional layers, an upper protective layer, a display panel, a lower protective layer, a support plate, and first and second adhesive layers) is listed in Table 3 below.

In Comparative Example 4, Comparative Example 5, and Comparative Example 6, the functional layers include an anti-fingerprint layer and a hard coating layer. The upper protective layer was formed using TAC. The display panel includes a substrate including glass, a wavelength conversion layer formed on the substrate, and a color filter layer formed on the wavelength conversion layer. The lower protective layer was formed using TPU. The support plate was formed by impregnating silicone resin with CFRP to form a base part including silicone resin and a plurality of support bars surrounded by the base part and including CFRP. The first and second adhesive layers were formed using PSA. However, in Comparative Example 5, the base part of the support plate was formed using polyurethane (PU) to be located under the support bars.

In Comparative Example 4, the thickness of a first part between the support bar of the support plate and the upper surface of the base part was 400 µm, the thickness of a second part between the support bar of the support plate and the lower surface of the base portion was 400 µm, and the thickness of the support bar was 800 µm. In addition, the support bar was formed to have a quadrangle shape in a cross-section.

In Comparative Example 5, the thickness of a first part between the support bar of the support plate and the upper surface of the base part was 200 µm, the thickness of a second part between the support bar of the support plate and the lower surface of the base portion was 200 µm, and the thickness of the support bar was 800 µm. In addition, the support bar was formed to have a quadrangle shape in a cross-section.

In Comparative Example 6, the thickness of a first part between the support bar of the support plate and the upper surface of the base part was 500 µm, the thickness of a second part between the support bar of the support plate and the lower surface of the base portion was 500 µm, and the thickness of the support bar was 1000 µm. In addition, the support bar was formed to have a quadrangle shape in a cross-section.

**Table 3**

| | Comparative Example 4 | Comparative Example 5 | Comparative Example 6 |
|---|---|---|---|
| A thickness of the functional layers | 12µm | 12µm | 12µm |
| A thickness of the upper protective layer | 60µm | 60µm | 60µm |
| A thickness of the first adhesive layer | 25µm | 25µm | 25µm |
| A thickness of the display panel | 135µm | 135µm | 135µm |
| A thickness of the second adhesive layer | 25µm | 25µm | 25µm |
| A thickness of the lower protective layer | 100µm | 100µm | 100µm |
| A thickness of the support plate | 1600µm | 1200µm | 2000µm |

According to Comparative Example 4, Comparative Example 5, and Comparative Example 6, the appearance of the support plate was observed and a tensile evaluation was performed on the support plate.

As a result, it can be confirmed that the appearance of the support plate in Comparative Example 6 is good compared to Comparative Examples 4 and 5. However, as a result of tensile evaluation of the support plate, it can be confirmed that the support plate was broken.

As shown in Table 3 below, a rolling display device was manufactured with a radius of curvature of 50R according to Comparative Example and Embodiment. The thickness of each of the components of the display device (e.g., functional layers, an upper protective layer, a display panel, a metal plate, a lower protective layer, a support plate, and first, second, and third adhesive layers) is listed in Table 4 below.

In Comparative Example 7 and Embodiment 2, the functional layers include an anti-fingerprint layer and a hard coating layer. The upper protective layer was formed using TAC. The display panel includes a substrate including glass, a wavelength conversion layer formed on the substrate, and a color filter layer formed on the wavelength conversion layer. The lower protective layer was formed using TPU.

The support plate was formed by impregnating silicone resin with CFRP to form a base part containing silicone resin and a plurality of support bars surrounded by the base part and containing CFRP. The first, second, and third adhesive layers were formed using PSA. However, in Comparative Example 7, the display device does not include the third adhesive layer, the lower protective layer, and the support plate.

The display device satisfying Embodiment 2 corresponds to the display device DD of FIGS. 1, 2, 3, and 4.

**Table 4**

| | Comparative Example 7 | Embodiment 2 |
|---|---|---|
| A thickness of the functional layers | 12µm | 12µm |
| A thickness of the upper protective layer | 60µm | 60µm |
| A thickness of the first adhesive layer | 25µm | 25µm |
| A thickness of the display panel | 135µm | 135µm |
| A thickness of the second adhesive layer | 25µm | 25µm |
| A thickness of the metal plate | 100µm | 100µm |
| A thickness of the third adhesive layer | -- | 75µm |
| A thickness of the lower protective layer | -- | 100µm |
| A thickness of the support plate | -- | 2000µm |

As a result, it can be confirmed that no cracks occur in the display panel of Embodiment 2 compared to Comparative Example 7. In contrast, in Comparative Example 7, it can be confirmed that cracks occurred in the display panel.

As a result, it can be confirmed as the display device according to embodiments of the present disclosure includes both the patterned metal plate located under the display module and the support plate located under the metal plate, the flexibility and rigidity of the display device can be secured at the same time.

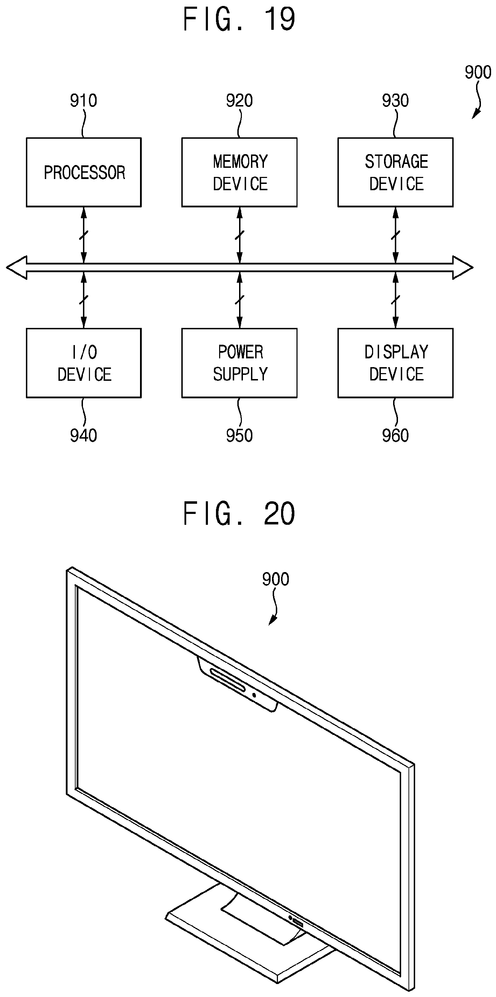

FIG. 19 is a block diagram illustrating an electronic device according to one or more embodiments of the present disclosure. FIG. 20 is a view illustrating an example in which the electronic device of FIG. 19 is implemented as a television.

Referring to FIGS. 19 and 20, in one or more embodiments, an electronic device 900 may include a processor 910, a memory device 920, a storage device 930, an input/output device 940, a power supply 950, and a display device 960. In this case, the display device 960 may correspond to the display device DD described with reference to FIGS. 1 to 18. The electronic device 900 may further include several ports capable of communicating with a video card, a sound card, a memory card, a USB device, and/or the like.

In one or more embodiments, as shown in FIG. 19, the electronic device 900 may be implemented as a television. However, the electronic device 900 is not limited thereto, and for example, the electronic device 900 may be implemented as a mobile phone, a video phone, a smart pad, a smart watch, a tablet PC, a vehicle navigation device, a computer monitor, a laptop computer, a head mounted display (HMD), and/or the like.

The processor 910 may perform certain calculations or tasks. In one or more embodiments, the processor 910 may be a microprocessor, a central processing unit (CPU), an application processor (AP), and/or the like. The processor 910 may be connected to other components through an address bus, a control bus, a data bus, and/or the like. The processor 910 may also be connected to an expansion bus, such as a peripheral component interconnect (PCI) bus.

The memory device 920 may store data suitable for the operation of the electronic device 900. For example, the memory device 920 may include an erasable programmable read-only memory (EPROM) device, an electrically erasable programmable read-only memory (EEPROM) device, a flash memory device, a phase change random access memory (PRAM) device, a resistance random access memory (RRAM) device, a nano floating GEe memory (NFGM) device, a polymer random access memory (PoRAM) device, a magnetic random access memory (MRAM) device, a non-volatile memory device, such as a ferroelectric random access memory (FRAM) device and/or a volatile memory device, such as a dynamic random access memory (DRAM) device, a static random access memory (SRAM) device, and a mobile DRAM device, and/or the like.

The storage device 930 may include a solid state drive (SSD), a hard disk drive (HDD), a CD-ROM, and/or the like.

The input/output device 940 may include input means, such as a keyboard, keypad, touch pad, touch screen, mouse, and/or the like and output means, such as a speaker, a printer, and/or the like.

The power supply 950 may supply power suitable for the operation of the electronic device 900. The display device 960 may be connected to other components through buses or other communication links. In one or more embodiments, the display device 960 may be included in the input/output device 940.

The present disclosure can be applied to various display devices. For example, the present disclosure is applicable to various display devices, such as display devices for vehicles, ships and aircraft, portable communication devices, display devices for exhibition or information transmission, medical display devices, and/or the like.

The foregoing is illustrative of embodiments and is not to be construed as limiting thereof. Although some embodiments have been described, those skilled in the art will readily appreciate that many modifications are possible in the embodiments without materially departing from the novel teachings and aspects of the present disclosure. Accordingly, all such modifications are intended to be included within the scope of the present disclosure as defined in the claims. Therefore, it is to be understood that the foregoing is illustrative of various embodiments and is not to be construed as limited to the embodiments disclosed, and that modifications to the disclosed embodiments, as well as other embodiments, are intended to be included within the scope of the appended claims.

## Claims

1. A display device (960) comprising:
a display module (DM) having flexibility;
a metal plate (MP) under the display module and patterned; and
a support plate (SP) under the metal plate and comprising a base part (BP) and support bars (SB) surrounded by the base part, each of the support bars (SB) extending in a horizontal direction parallel to an upper surface of the display module,
wherein surfaces of the support bars (SB) of the support plate (SP) are spaced apart from a surface of the base part (BP); and
a lower protective layer (LPF) disposed between the metal plate (MP) and the support plate (SP).

2. The display device (960) of claim 1, wherein a thickness of the metal plate (MP) is different from a thickness of the support plate.

3. The display device (960) of claim 1 or 2, wherein a thickness of the metal plate (MP) is between 0.05 mm and 0.3 mm.

4. The display device (960) of any of the preceding claims, wherein a thickness of the support plate is between 1.0 mm and 5.0 mm.

5. The display device (960) of any of the preceding claims, wherein the metal plate (MP) comprises stainless steel.

6. The display device (960) of any of the preceding claims, wherein the metal plate (MP) has a lattice shape in a plan view.

7. The display device (960) of any of claims 1 to 5, wherein the metal plate (MP) comprises an auxetic structure having a negative Poisson's ratio.

8. The display device (960) of claim 7, wherein the auxetic structure of the metal plate (MP) comprises patterns having a same planar shape and connected to each other.

9. The display device (960) of claim 7 or 8, wherein the auxetic structure of the metal plate (MP) comprises patterns connected to one another, and
wherein the patterns comprise a closed line pattern and line parts extending from the closed line pattern and spaced apart from each other.

10. The display device (960) of any of the preceding claims, wherein the support bars (SB) are impregnated into the base part.

11. The display device (960) of any of the preceding claims, wherein the support bars (SB) have a polygonal shape in a cross-section.

12. The display device (960) of any of the preceding claims, wherein the base part (BP) comprises a flexible silicon resin.

13. The display device (960) of any of the preceding claims, wherein the support bars (SB) are repeatedly arranged along a first direction and extend in a second direction crossing the first direction.

14. The display device (960) of any of the preceding claims, wherein the support bars (SB) comprise carbon fiber reinforced plastic, CFRP, or glass fiber reinforced plastic, GFRP, and/or wherein the display module (DM) comprises:
a light-emitting element above a substrate;
a color conversion layer above the light-emitting element and comprising quantum dots; and
a color filter layer above the color conversion layer.

15. An electronic device (900) comprising:
an accommodating portion;
a roller inside the accommodating portion, extending in a first direction, and configured to rotate; and
a display device (960) as claimed in any of the preceding claims.

## Patentansprüche

1. Anzeigevorrichtung (960), umfassend:
ein Anzeigemodul (DM) mit Flexibilität;
eine unterhalb des Anzeigemoduls angeordnete und strukturierte Metallplatte (MP); und
eine Stützplatte (SP) unterhalb der Metallplatte, die einen Basisteil (BP) und von dem Basisteil umgebene Stützstangen (SB) umfasst, wobei sich jede der Stützstangen (SB) in horizontaler Richtung parallel zu einer Oberseite des Anzeigemoduls erstreckt,
wobei Oberflächen der Stützstangen (SB) der Stützplatte (SP) von einer Oberfläche des Basisteils (BP) beabstandet sind; und
eine untere Schutzschicht (LPF), die zwischen der Metallplatte (MP) und der Stützplatte (SP) angeordnet ist.

2. Anzeigevorrichtung (960) nach Anspruch 1, wobei sich eine Dicke der Metallplatte (MP) von einer Dicke der Stützplatte unterscheidet.

3. Anzeigevorrichtung (960) nach Anspruch 1 oder 2, wobei eine Dicke der Metallplatte (MP) zwischen 0,05 mm und 0,3 mm liegt.

4. Anzeigevorrichtung (960) nach einem der vorstehenden Ansprüche, wobei eine Dicke der Stützplatte zwischen 1,0 mm und 5,0 mm liegt.

5. Anzeigevorrichtung (960) nach einem der vorstehenden Ansprüche, wobei die Metallplatte (MP) Edelstahl umfasst.

6. Anzeigevorrichtung (960) nach einem der vorstehenden Ansprüche, wobei die Metallplatte (MP) in der Draufsicht eine Gitterform aufweist.

7. Anzeigevorrichtung (960) nach einem der Ansprüche 1 bis 5, wobei die Metallplatte (MP) eine auxetische Struktur mit einer negativen Poissonzahl umfasst.

8. Anzeigevorrichtung (960) nach Anspruch 7, wobei die auxetische Struktur der Metallplatte (MP) Muster umfasst, die eine gleiche ebene Form aufweisen und miteinander verbunden sind.

9. Anzeigevorrichtung (960) nach Anspruch 7 oder 8, wobei die auxetische Struktur der Metallplatte (MP) miteinander verbundene Muster umfasst, und
wobei die Muster ein geschlossenes Linienmuster und sich von dem geschlossenen Linienmuster erstreckende, voneinander beabstandete Linienteile umfassen.

10. Anzeigevorrichtung (960) nach einem der vorstehenden Ansprüche, wobei die Stützstangen (SB) in den Basisteil imprägniert sind.

11. Anzeigevorrichtung (960) nach einem der vorstehenden Ansprüche, wobei die Stützstangen (SB) in einem Querschnitt eine polygonale Form aufweisen.

12. Anzeigevorrichtung (960) nach einem der vorstehenden Ansprüche, wobei der Basisteil (BP) ein flexibles Silikonharz umfasst.

13. Anzeigevorrichtung (960) nach einem der vorstehenden Ansprüche, wobei die Stützstangen (SB) wiederholt entlang einer ersten Richtung angeordnet sind und sich in einer zweiten Richtung erstrecken, die die erste Richtung kreuzt.

14. Anzeigevorrichtung (960) nach einem der vorstehenden Ansprüche, wobei die Stützstangen (SB) carbonfaserverstärkten Kunststoff, CFK, oder glasfaserverstärkten Kunststoff, GFK, umfassen, und/oder wobei das Anzeigemodul (DM) Folgendes umfasst:
ein lichtemittierendes Element über einem Substrat;
eine Farbkonversionsschicht über dem lichtemittierenden Element, die Quantenpunkte umfasst; und
eine Farbfilterschicht über der Farbkonversionsschicht.

15. Elektronische Vorrichtung (900), umfassend:
einen Aufnahmeabschnitt;
eine Rolle innerhalb des Aufnahmeabschnitts, die sich in einer ersten Richtung erstreckt und zur Drehung konfiguriert ist; und
eine Anzeigevorrichtung (960) nach einem der vorstehenden Ansprüche.

## Revendications

1. Dispositif d'affichage (960) comportant :
un module d'affichage (DM) présentant une certaine souplesse ;
une plaque métallique (MP) située sous le module d'affichage et présentant des motifs ; et
une plaque de support (SP) située sous la plaque métallique et comportant une partie de base (BP) et des barres de support (SB) entourées par la partie de base, chacune des barres de support (SB) s'étendant dans une direction horizontale parallèle à une surface supérieure du module d'affichage, dans lequel des surfaces des barres de support (SB) de la plaque de support (SP) sont espacées d'une surface de la partie de base (BP) ; et
une couche de protection inférieure (LPF) disposée entre la plaque métallique (MP) et la plaque de support (SP).

2. Dispositif d'affichage (960) selon la revendication 1, dans lequel une épaisseur de la plaque métallique (MP) est différente d'une épaisseur de la plaque de support.

3. Dispositif d'affichage (960) selon la revendication 1 ou 2, dans lequel une épaisseur de la plaque métallique (MP) est comprise entre 0,05 mm et 0,3 mm.

4. Dispositif d'affichage (960) selon l'une quelconque des revendications précédentes, dans lequel une épaisseur de la plaque de support est comprise entre 1,0 mm et 5,0 mm.

5. Dispositif d'affichage (960) selon l'une quelconque des revendications précédentes, dans lequel la plaque métallique (MP) comporte de l'acier inoxydable.

6. Dispositif d'affichage (960) selon l'une quelconque des revendications précédentes, dans lequel la plaque métallique (MP) présente une forme de grille en vue en plan.

7. Dispositif d'affichage (960) selon l'une quelconque des revendications 1 à 5, dans lequel la plaque métallique (MP) comporte une structure auxétique présentant un coefficient de Poisson négatif.

8. Dispositif d'affichage (960) selon la revendication 7, dans lequel la structure auxétique de la plaque métallique (MP) comporte des motifs présentant une même forme plane et reliés entre eux.

9. Dispositif d'affichage (960) selon la revendication 7 ou 8, dans lequel la structure auxétique de la plaque métallique (MP) comporte des motifs reliés entre eux, et
dans lequel les motifs comportent un motif de ligne fermé et des parties de ligne s'étendant à partir du motif de ligne fermé et espacées les unes des autres.

10. Dispositif d'affichage (960) selon l'une quelconque des revendications précédentes, dans lequel les barres de support (SB) sont imprégnées dans la partie de base.

11. Dispositif d'affichage (960) selon l'une quelconque des revendications précédentes, dans lequel les barres de support (SB) présentent une forme polygonale en coupe transversale.

12. Dispositif d'affichage (960) selon l'une quelconque des revendications précédentes, dans lequel la partie de base (BP) comporte une résine de silicium souple.

13. Dispositif d'affichage (960) selon l'une quelconque des revendications précédentes, dans lequel les barres de support (SB) sont agencées de manière répétée le long d'une première direction et s'étendent dans une deuxième direction croisant la première direction.

14. Dispositif d'affichage (960) selon l'une quelconque des revendications précédentes, dans lequel les barres de support (SB) comportent du plastique renforcé de fibres de carbone, CFRP, ou du plastique renforcé de fibres de verre, GFRP, et/ou dans lequel le module d'affichage (DM) comporte :
un élément électroluminescent situé au-dessus d'un substrat ;
une couche de conversion de couleur située au-dessus de l'élément électroluminescent et comportant des points quantiques ; et
une couche de filtre de couleur située au-dessus de la couche de conversion de couleur.

15. Dispositif électronique (900) comportant :
une partie de logement ;
un rouleau à l'intérieur de la partie de logement, s'étendant dans une première direction, et configuré pour tourner ; et
un dispositif d'affichage (960) selon l'une quelconque des revendications précédentes.
